# EUROPÄISCHE PATENTSCHRIFT

(11) **EP 2 245 657 B1**
(45) Veröffentlichungstag und Bekanntmachung des Hinweises auf die Patenterteilung: **21.11.2018**
(21) Anmeldenummer: 09712295.6
(22) Anmeldetag: 11.02.2009
(51) Int. Cl.: H01L 33/20, H01L 33/00, H01L 33/44, H01S 5/02, H01S 5/323

(54) **OPTOELEKTRONISCHER HALBLEITERKÖRPER UND VERFAHREN ZUR HERSTELLUNG EINES OPTOELEKTRONISCHEN HALBLEITERKÖRPERS**
OPTOELECTRONIC SEMICONDUCTOR BODY AND METHOD FOR PRODUCING AN OPTOELECTRONIC SEMICONDUCTOR BODY
COMPOSANT À SEMI-CONDUCTEURS OPTO-ÉLECTRONIQUE ET PROCÉDÉ DE FABRICATION D'UN COMPOSANT À SEMI-CONDUCTEURS OPTO-ÉLECTRONIQUE

(30) Priorität: 22.02.2008 DE 102008010508; 09.04.2008 DE 102008018038
(43) Veröffentlichungstag der Anmeldung: 03.11.2010
(73) Patentinhaber: OSRAM Opto Semiconductors GmbH, 93055 Regensburg (DE)
(72) Erfinder: BRÜNINGHOFF, Stefanie, 93197 Zeitlarn (DE); EICHLER, Christoph, 93105 Tegernheim (DE)
(74) Vertreter: Epping - Hermann - Fischer
(86) Internationale Anmeldenummer: PCT/DE2009/000191
(87) Internationale Veröffentlichungsnummer: WO 2009/103266

(56) Entgegenhaltungen:
- DE-A1- 3 731 312
- US-A1- 2003 169 796
- US-A1- 2005 277 212
- US-A1- 2007 051 961
- US-A1- 2007 121 692
- US-A1- 2007 221 932
- Shigetoshi Ito ET AL: "High power violet laser diodes with crack-free layers on GaN substrates", Physica Status Solidi. A: Applications and Materials Science, vol. 204, no. 6, 1 June 2007 (2007-06-01), pages 2073-2076, XP055446309, DE ISSN: 1862-6300, DOI: 10.1002/pssa.200674755

## Beschreibung

Die vorliegende Erfindung betrifft einen optoelektronischen Halbleiterkörper und ein Verfahren zur Herstellung eines optoelektronischen Halbleiterkörpers.

Optoelektronische Halbleiterkörper werden zur Erzeugung von elektromagnetischer Strahlung üblicherweise als eine Halbleiterschichtenfolge auf einem Substrat hergestellt. Eine derartige Halbleiterschichtenfolge wird üblicherweise mittels Epitaxie auf einem Substrat abgeschieden. Zur Herstellung von Laserdioden können beispielsweise auf einem n-dotierten Galliumnitrid-Substrat, das einen geringen Kristallversatz aufweist, nachfolgend n- und p-dotierte Schichten mit einem dazwischen liegenden, zur Strahlungserzeugung geeigneten aktiven Bereich aufgebracht werden. Dabei werden so genannte Hetero-Epitaxieverfahren ausgeführt, um unterschiedliche Verbindungshalbleiter wie beispielsweise Aluminiumgalliumnitrid oder Indiumgalliumnitrid auf Galliumnitrid aufzubringen. Bei der Abscheidung von nicht-gitterangepassten Verbindungshalbleitern können mechanische Verspannungen zwischen der Halbleiterschichtenfolge und dem Substrat auftreten. Derartige Verspannungen können zu Verbiegungen des Substrats oder zu Rissen in der Halbleiterschichtenfolge führen.

Wie in dem Artikel von S. Ito et al., "High Power violet laser diodes with crack-free layers on GaN substrates", Phys. Stat. Sol (a) 204, No. 6, 2007, Seite 2073 - 2076, beschrieben wird, können Verspannungen durch mehrere, parallel zueinander auf dem Substrat angeordnete Gräben reduziert werden. Dabei wird vor dem Bilden einer epitaktischen Schicht ein Prozess zum Bilden mehrerer Gräben durchgeführt, so dass nach der epitaktischen Abscheidung die Oberfläche des Substrats von einer Schicht konform bedeckt ist, wobei die Gräben nicht vollständig aufgefüllt werden, sondern lediglich ihre Seitenwand bedeckt wird. Demgemäß wird durch das Vorhandensein einer Diskontinuität in der epitaktischen Schicht das Auftreten von Verspannungen und/oder Rissen vermindert.

Die Druckschriften US 2007/0121692 A1, US 2007/0221932 A1, US 2007/0051961 A1 und US 2005/0277212 A1 beschreiben optoelektronischen Halbleiterkörper und deren Herstellung.

Die Erfindung ist in den unabhängigen Ansprüchen 1 und 11 definiert. Vorteilhafte Weiterbildungen der Erfindung sind in den zugehörigen abhängigen Ansprüchen angegeben.

Aufgabe ist es, einen verbesserten optoelektronischen Halbleiterkörper bereitzustellen beziehungsweise ein Verfahren zur Herstellung eines verbesserten optoelektronischen Halbleiterkörpers anzugeben.

Diese Aufgabe wird in ihrem ersten Aspekt mit einem optoelektronischen Halbleiterkörper gelöst, der ein Substrat, das auf einer ersten Hauptfläche in einem ersten Bereich eine zur Erzeugung von elektromagnetischer Strahlung geeignete, epitaktische Halbleiterschichtenfolge und in einem zu dem ersten Bereich benachbarten zweiten Bereich einen ersten Graben aufweist und wenigstens einen zweiten Graben, der außerhalb des ersten Bereichs angeordnet ist, umfasst.

Es ist zum Beispiel vorgesehen, dass auf dem Substrat benachbart zu der epitaktische Halbleiterschichtenfolge in dem zweiten Bereich ein erster Graben ausgebildet wird, der geeignet ist, Verspannungen während des Bildens der epitaktischen Halbleiterschichtenfolge zu reduzieren. Die epitaktische Halbleiterschichtenfolge weist jedoch insbesondere im Bereich der Seitenwände des ersten Grabens eine gestörte Zone auf. Diese gestörten Bereiche können nach Fertigstellung des optoelektronischen Halbleiterkörpers zu Nebenschlüssen führen, die die Bauteilefunktion beeinträchtigen können. Um diese Störungen zu reduzieren oder zu beseitigen, wird wenigstens ein zweiter Graben ausgebildet, der benachbart zu der epitaktischen Halbleiterschichtenfolge angeordnet ist. Folglich können beim Bilden der epitaktischen Halbleiterschichtenfolge auftretende Diskontinuitäten in der epitaktisch aufgebrachten Halbleiterschichtenfolge keine Störungen verursachen beziehungsweise die Bauteilefunktion beeinträchtigen.

In einer weiteren Ausführungsform ist bei dem optoelektronischen Halbleiterkörper der zweite Graben so angeordnet, dass der erste Graben überdeckt ist.

Gemäß dieser Ausführungsform wird durch Bilden eines zweiten Grabens die epitaktische Halbleiterschichtenfolge im Bereich des ersten Grabens entfernt, so dass die im Bereich der Seitenwände des ersten Grabens liegende gestörte Zone in der epitaktisch aufgebrachten Halbleiterschichtenfolge keine Störungen verursachen beziehungsweise die Bauteilefunktion beeinträchtigen kann, die auf undefinierte Schichtendicken oder unregelmäßiges Kristallwachstum der epitaktischen Halbleiterschichtenfolge zurückzuführen wäre. Diese gestörten Bereiche können nach Fertigstellung des optoelektronischen Halbleiterkörpers zu Nebenschlüssen führen, die die Bauteilefunktion beeinträchtigen können.

In einer weiteren Ausführungsform ist bei dem optoelektronischen Halbleiterkörper der zweite Graben als Trenngraben benachbart zum ersten Graben angeordnet.

Gemäß dieser Ausführungsform wird durch Bilden eines zweiten Grabens die epitaktische Halbleiterschichtenfolge von der gestörten Zone in der epitaktisch aufgebrachten Halbleiterschichtenfolge, die im Bereich der Seitenwände des ersten Grabens liegt, getrennt, so dass diese keine Störungen verursachen oder die Bauteilefunktion beeinträchtigen kann.

In einer weiteren Ausführungsform ist bei dem optoelektronischen Halbleiterkörper der zweite Graben als Trenngraben jeweils auf beiden Seiten des ersten Grabens benachbart zum ersten Graben angeordnet.

Gemäß dieser Ausführungsform ist eine Trennung der gestörten Zone der epitaktisch aufgebrachten Halbleiterschichtenfolge zu aktiven Bereichen in beide Richtungen vorgesehen, so dass Störungen reduziert werden.

In einer weiteren Ausführungsform ist bei dem optoelektronischen Halbleiterkörper auf der ersten Hauptfläche in dem zweiten Bereich eine Passivierungsschicht aufgebracht, die den zweiten Graben wenigstens teilweise bedeckt.

Gemäß dieser Ausführungsform ist zusätzlich zur Trennung der gestörten Zone der epitaktischen Halbleiterschichtenfolge zu aktiven Bereichen eine Passivierung vorgesehen, die elektrische Nebenschlüsse oder Kriechströme verhindern kann sowie zur Erhöhung der ESD-Festigkeit dient.

Diese Aufgabe wird in ihrem zweiten Aspekt durch einem Verfahren zur Herstellung eines optoelektronischen Halbleiterkörpers gelöst, bei dem die folgenden Schritte ausgeführt werden:
- Bereitstellen eines Substrats mit einer ersten Hauptfläche,
- Bilden eines ersten Grabens in der ersten Hauptfläche,
- epitaktisches Aufwachsen einer Halbleiterschichtenfolge, die eine zur Erzeugung der elektromagnetischen Strahlung geeignete aktive Schicht aufweist, in einem ersten Bereich auf der ersten Hauptfläche,
- Bilden wenigstens eines zweiten Grabens, der außerhalb des ersten Bereichs in einem zu dem ersten Bereich benachbarten zweiten Bereich angeordnet ist.

Es ist vorgesehen, dass auf dem Substrat benachbart zu der epitaktischen Halbleiterschichtenfolge in dem zweiten Bereich ein erster Graben ausgebildet wird, der geeignet ist, Verspannungen während des Bildens der epitaktischen Halbleiterschichtenfolge zu reduzieren. Die epitaktische Halbleiterschichtenfolge weist jedoch insbesondere im Bereich der Seitenwände des ersten Grabens eine gestörte Zone auf, die auf undefinierte Schichtendicken oder unregelmäßiges Kristallwachstum der epitaktischen Halbleiterschichtenfolge zurückzuführen ist.

Diese gestörten Bereiche können nach Fertigstellung des optoelektronischen Halbleiterkörpers zu Nebenschlüssen führen, die die Bauteilefunktion beeinträchtigen können. Um diese Störungen zu reduzieren oder zu beseitigen, wird wenigstens ein zweiter Graben ausgebildet, der benachbart zu der epitaktischen Halbleiterschichtenfolge angeordnet wird. Folglich können beim Bilden der epitaktischen Halbleiterschichtenfolge auftretende Diskontinuitäten in der epitaktisch aufgebrachten Halbleiterschichtenfolge keine Störungen verursachen beziehungsweise die Bauteilefunktion beeinträchtigen.

Gemäß zumindest einer Ausführungsform des hier beschriebenen Verfahrens und/oder des hier beschriebenen Halbleiterkörpers wird ein Halbleiterkörper angegeben, bei dem der zweite Graben so angeordnet ist, dass der erste Graben überdeckt ist.

Gemäß zumindest einer Ausführungsform des hier beschriebenen Verfahrens und/oder des hier beschriebenen Halbleiterkörpers wird ein Halbleiterkörper angegeben, bei dem der zweite Graben als Trenngraben benachbart zum ersten Graben angeordnet ist.

Gemäß zumindest einer Ausführungsform des hier beschriebenen Verfahrens und/oder des hier beschriebenen Halbleiterkörpers wird ein Halbleiterkörper angegeben, bei dem der zweite Graben als Trenngraben jeweils auf beiden Seiten des ersten Grabens benachbart zum ersten Graben angeordnet ist.

Gemäß zumindest einer Ausführungsform des hier beschriebenen Verfahrens und/oder des hier beschriebenen Halbleiterkörpers wird ein Halbleiterkörper angegeben, bei dem auf der ersten Hauptfläche in dem zweiten Bereich eine Passivierungsschicht aufgebracht ist, die den zweiten Graben wenigstens teilweise bedeckt.

Gemäß zumindest einer Ausführungsform des hier beschriebenen Verfahrens und/oder des hier beschriebenen Halbleiterkörpers wird ein Halbleiterkörper angegeben, bei dem die Passivierungsschicht darüber hinaus Seitenwände der epitaktischen Halbleiterschichtenfolge wenigstens teilweise bedeckt.

Gemäß zumindest einer Ausführungsform des hier beschriebenen Verfahrens und/oder des hier beschriebenen Halbleiterkörpers wird ein Halbleiterkörper angegeben, bei dem die Passivierungsschicht Seitenwände des zweiten Grabens wenigstens teilweise bedeckt.

Gemäß zumindest einer Ausführungsform des hier beschriebenen Verfahrens und/oder des hier beschriebenen Halbleiterkörpers wird ein Halbleiterkörper angegeben, bei dem die Passivierungsschicht den Halbleiterkörper vollständig bedeckt.

Gemäß zumindest einer Ausführungsform des hier beschriebenen Verfahrens und/oder des hier beschriebenen Halbleiterkörpers wird ein Halbleiterkörper angegeben, bei dem die Passivierungsschicht eine Oxid-, Nitrid- oder Fluoridverbindung umfasst.

Gemäß zumindest einer Ausführungsform des hier beschriebenen Verfahrens und/oder des hier beschriebenen Halbleiterkörpers wird ein Halbleiterkörper angegeben, bei dem der zweite Graben von der ersten Hauptfläche bis in das darunter liegende Substrat reicht.

Gemäß zumindest einer Ausführungsform des hier beschriebenen Verfahrens und/oder des hier beschriebenen Halbleiterkörpers wird ein Halbleiterkörper angegeben, bei dem der zweite Graben von der ersten Hauptfläche aus die epitaktische Schichtenfolge wenigstens teilweise durchtrennt.

Gemäß zumindest einer Ausführungsform des hier beschriebenen Verfahrens und/oder des hier beschriebenen Halbleiterkörpers wird ein Halbleiterkörper angegeben, bei dem der erste Bereich einen Laser oder eine Leuchtdiode umfasst.

Gemäß zumindest einer Ausführungsform des hier beschriebenen Verfahrens und/oder des hier beschriebenen Halbleiterkörpers wird ein Halbleiterkörper angegeben,
bei dem der Laser als Rippe auf der ersten Hauptfläche des Substrates angeordnet ist.

Der hier beschriebene optoelektronische Halbleiterkörper und das hier beschriebene Verfahren zur Herstellung eines optoelektronischen Halbleiterkörpers werden nachfolgend an mehreren Ausführungsbeispielen anhand der Figuren näher erläutert. Funktions- beziehungsweise wirkungsgleiche Schichten, Bereiche und Strukturen tragen jeweils gleiche Bezugszeichen. Insoweit sich Schichten, Bereiche oder Strukturen in ihrer Funktion entsprechen, wird deren Beschreibung nicht in jeder der folgenden Figuren wiederholt.

Es zeigen:
- Figur 1A: eine beispielhafte Ausführungsform eines optoelektronischen Halbleiterkörpers in einer Draufsicht,
- Figur 1B: eine beispielhafte Ausführungsform einer Schichtenfolge eines optoelektronischen Halbleiterkörpers in einer perspektivischen Seitenansicht,
- Figuren 2A bis 2C: Beispiele einer Schichtenfolge eines optoelektronischen Halbleiterkörpers in einer Querschnittsansicht,
- Figuren 3A bis 3C: beispielhaft Ausführungsformen einer Schichtenfolge eines optoelektronischen Halbleiterkörpers in einer Querschnittsansicht,
- Figuren 4A bis 4C: beispielhaft Ausführungsformen einer Schichtenfolge eines optoelektronischen Halbleiterkörpers in einer Querschnittsansicht,
- Figur 5: beispielhaft eine Ausführungsform einer Schichtenfolge eines optoelektronischen Halbleiterkörpers in einer Querschnittsansicht,
- Figur 6: beispielhaft eine Ausführungsform einer Schichtenfolge eines optoelektronischen Halbleiterkörpers in einer Querschnittsansicht,
- Figur 7: ein Beispiel einer Schichtenfolge eines optoelektronischen Halbleiterkörpers in einer Querschnittsansicht,
- Figur 8: ein Beispiel einer Schichtenfolge eines optoelektronischen Halbleiterkörpers in einer Querschnittsansicht, und
- Figur 9: ein Flussdiagramm der erfindungsgemäßen Schritte eines Verfahrens zum Herstellen eines optoelektronischen Halbleiterkörpers.

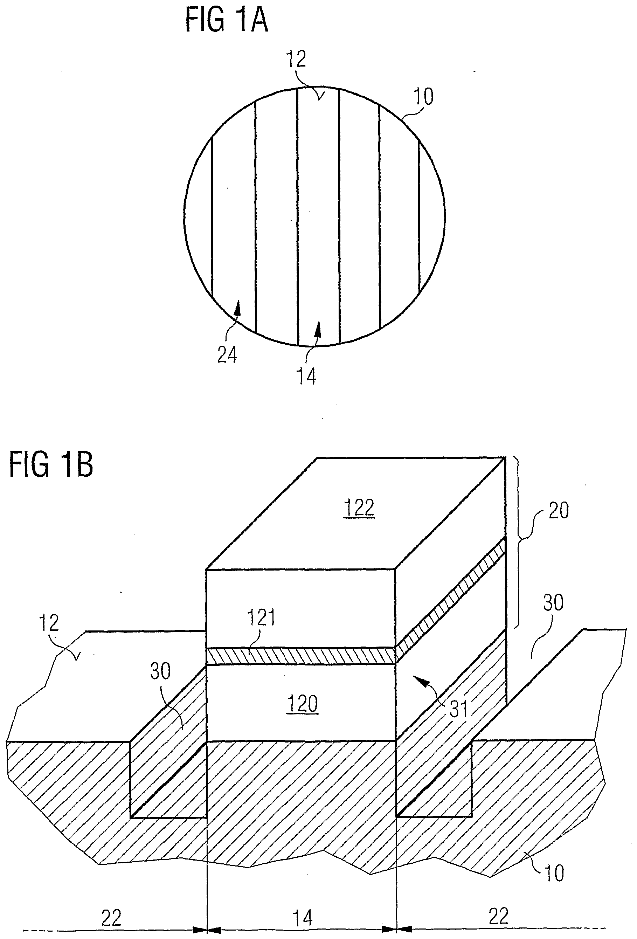

In Figur 1A ist in einer Draufsicht eine beispielhafte Ausführungsform eines optoelektronischen Halbleiterkörpers gezeigt. Auf einem Substrat 10, beispielsweise ein Halbleiterwafer, wird durch epitaktisches Abscheiden eine Halbleiterschichtenfolge 20 gebildet. Üblicherweise wird zur Herstellung einer Laserdiode ein n-leitendes Substrat 10 aus Galliumnitrid mit einer n-dotierten Schicht aus Galliumnitrid, eine aktive Schicht und darüber eine p-dotierte Schicht ebenfalls aus Galliumnitrid gebildet. Als aktive Schicht sind beispielsweise Quantentopfstrukturen umfassen Indiumgalliumnitrid vorgesehen. Darüber hinaus können zur Erhöhung der Bauteilefunktionalität beziehungsweise Leistungsverbesserung weitere Schichten, beispielsweise dotierte Verbindungsschichten (so genannte "cladding layer"), Kontaktschichten oder Schichten zum Verhindern von Materialverunreinigungen (so genannte "evaporation preventing layer") gebildet sein, die zur Vereinfachung der Darstellung der Erfindung im Folgenden nicht gezeigt werden. Dem kundigen Fachmann ist jedoch deren Funktion bekannt und es können gegebenenfalls weitere Maßnahmen getroffen werden, die zur Verbesserung der Bauteilefunktionalität beziehungsweise Leistung einer Laserdiode dienen können. Des Weiteren umfasst eine vollständig hergestellte Laserdiode auf einem Substrat 10 noch weitere Elemente, wie zum Beispiel Kontaktflächen oder Auskoppelelemente, die dem Fachmann jedoch bekannt sind.

Wie bereits eingangs erwähnt, können bei der Abscheidung von nicht-gitterangepassten Verbindungshalbleitern mechanische Verspannungen zwischen der Halbleiterschichtenfolge und dem Substrat auftreten, die zu Verbiegungen des Substrats oder zu Rissen in der Halbleiterschichtenfolge führen können.

Um diese Effekte zu minimieren, wird, wie in Figur 1A gezeigt, auf dem Substrat 10 auf einer ersten Hauptfläche 12 benachbart zu der epitaktische Halbleiterschichtenfolge ein erster Graben 24 ausgebildet, der geeignet ist, Verspannungen während des Bildens der Halbleiterschichtenfolge in einem ersten Bereich 14 zu reduzieren. Dieser erste Graben 24 kann beispielsweise entlang einer Kristallorientierung des Substrats 10 ausgeführt werden. Es ist aber auch vorgesehen, dass die Ausrichtung des ersten Grabens 24 eine beliebige Richtung relativ zur Kristallorientierung des Substrats 10 aufweist.

Zur Verdeutlichung wird in Figur 1B ein Ausschnitt einer beispielhaften Ausführungsform einer Schichtenfolge eines optoelektronischen Halbleiterkörpers in einer perspektivischen Seitenansicht gezeigt. Auf dem Substrat 10 wird auf der ersten Hauptfläche 12 benachbart zu der epitaktischen Halbleiterschichtenfolge 20 der erste Graben 24 in einem zweiten Bereich 22 gebildet, um Verspannungen während des Bildens der Halbleiterschichtenfolge 20 in dem ersten Bereich 14 zu reduzieren. Die Halbleiterschichtenfolge 20 umfasst dabei wenigstens drei Teilschichten 120 bis 122, die beispielsweise durch eine n-dotierte Schicht 120, eine aktive Schicht 121 und eine p-dotierte Schicht 122 gebildet werden.

Wie in Figur 1B gezeigt ist, ist ein zweiter Graben 30 derart im zweiten Bereich 22 gebildet, dass die der epitaktischen Halbleiterschichtenfolge 20 zugewandten Seitenwände 31 nicht von den epitaktisch aufgebrachten Schichten bedeckt sind. Die Halbleiterschichtenfolge 20 würde jedoch während des epitaktischen Aufwachsens insbesondere im Bereich von Seitenwänden des ersten Grabens 24 eine gestörte Zone aufweisen, die auf undefinierte Schichtendicken oder unregelmäßiges Kristallwachstum der epitaktischen Halbleiterschichtenfolge 20 zurückzuführen ist.

Diese gestörten Bereiche können nach Fertigstellung des optoelektronischen Halbleiterkörpers zu Nebenschlüssen führen, die die Bauteilefunktion beeinträchtigen können. Um diese Störungen zu reduzieren oder zu beseitigen, wird der zweite Graben 30 ausgebildet, der benachbart zu der epitaktischen Halbleiterschichtenfolge 20 angeordnet wird. Folglich können die beim Bilden der epitaktischen Halbleiterschichtenfolge 20 auftretenden Diskontinuitäten in der epitaktisch aufgebrachten Halbleiterschichtenfolge keine Störungen verursachen beziehungsweise die Bauteilefunktion beeinträchtigen.

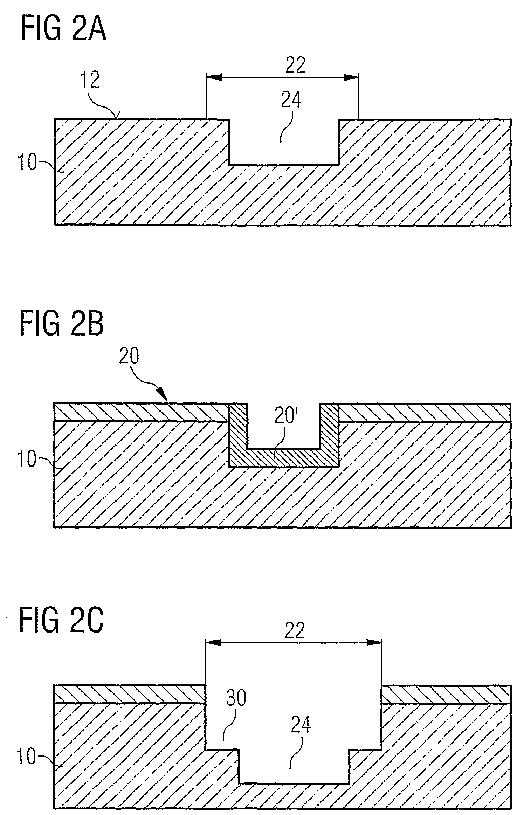

Verschiedene Möglichkeiten zur Reduzierung beziehungsweise zur Verhinderung von Diskontinuitäten in der epitaktisch aufgebrachten Halbleiterschichtenfolge 20 werden im Folgenden in Bezug auf die Figuren 2 bis 4 erläutert.

In Figur 2A ist ein Beispiel eines optoelektronischen Halbleiterkörpers in einer Querschnittsansicht durch ein Substrat 10 vor dem epitaktischen Aufbringen der Halbleiterschichtenfolge 20 gezeigt, bei welchem es sich nicht um ein Ausführungsbeispiel handelt. In Figur 2A ist im zweiten Bereich 22 der erste Graben 24 im Substrat 10 beispielsweise durch geeignete Ätzschritte unter Verwendung einer Maske gebildet worden.

Wie in Figur 2B gezeigt ist, erfolgt danach das epitaktische Aufbringen der Halbleiterschichtenfolge 20. Dabei wird in einem ersten Prozessschritt beispielsweise die n-dotierte Schicht 120 durch ein Epitaxieverfahren, beispielsweise die in der Technik bekannten MOVPE- oder MBE-Verfahren, vollflächig auf der ersten Hauptfläche 12 des Substrats 10 abgeschieden. Die Halbleiterschichtenfolge 20 kann während des epitaktischen Aufwachsens insbesondere im Bereich von Seitenwänden des ersten Grabens 24 aber auch an der Unterseite des Grabens 24 eine gestörte Zone aufweisen, die auf undefinierte Schichtendicken oder unregelmäßiges Kristallwachstum der epitaktischen Halbleiterschichtenfolge 20 zurückzuführen ist. Der Bereich der möglicherweise gestörten Zone ist in Figur 2B mit dem Bezugszeichen 20' gekennzeichnet.

Um die Einflüsse der beim Bilden der epitaktischen Halbleiterschichtenfolge möglicherweise auftretenden Diskontinuitäten in der gestörten Zone zu reduzieren, ist es vorgesehen, einen zweiten Graben 30 so anzubringen, dass der zweite Graben 30 den ersten
Graben überspannt, das heißt eine Breite aufweist, die größer als die Breite des ersten Grabens 24 ist.

Wie in Figur 2C gezeigt ist, wird somit die epitaktisch aufgewachsene Schicht 20' im Bereich von Seitenwänden des ersten Grabens 24 und an der Unterseite des Grabens 24 entfernt. Dies kann beispielsweise durch einen zweiten Ätzschritt unter Verwendung einer geeigneten Maske bewirkt werden. Folglich ist der Bereich der gestörten Zone vollständig entfernt, so dass dieser keine Störungen verursachen beziehungsweise die Bauteilefunktion beeinträchtigen kann. Demgemäß wird die Gefahr von Nebenschlüssen nach Fertigstellung des optoelektronischen Halbleiterkörpers reduziert.

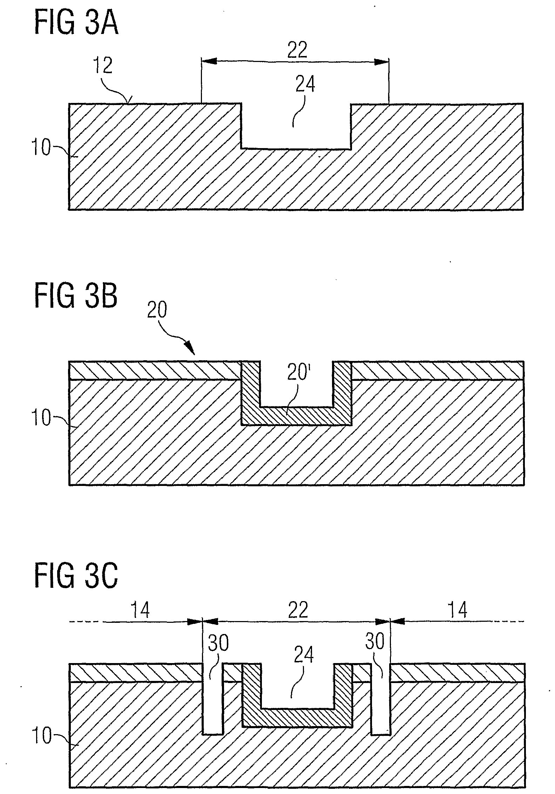

In Figur 3A ist in einem weiteren Beispiel eine weitere Ausführungsform eines optoelektronischen Halbleiterkörpers in einer Querschnittsansicht durch ein Substrat 10 vor dem epitaktischen Aufbringen der Halbleiterschichtenfolge 20 gezeigt. In Figur 3A ist im zweiten Bereich 22 der erste Graben 24 im Substrat 10 beispielsweise durch geeignete Ätzschritte unter Verwendung einer Maske gebildet worden.

Wie in Figur 3B gezeigt ist, erfolgt danach das epitaktische Aufbringen der Halbleiterschichtenfolge 20. Dabei wird in einem ersten Prozessschritt beispielsweise die n-dotierte Schicht 120 durch ein Epitaxieverfahren vollflächig auf der ersten Hauptfläche 12 des Substrats 10 abgeschieden. Die Halbleiterschichtenfolge 20 kann während des epitaktischen Aufwachsens insbesondere im Bereich von Seitenwänden des ersten Grabens 24, aber auch an der Unterseite des Grabens 24 eine gestörte Zone aufweisen, die auf undefinierte Schichtendicken oder unregelmäßiges Kristallwachstum der epitaktischen Halbleiterschichtenfolge 20 zurückzuführen ist.

Der Bereich der möglicherweise gestörten Zone ist in Figur 3B mit dem Bezugszeichen 20' gekennzeichnet.

Wie in Figur 3C gezeigt, ist es gemäß dieser Ausführungsform vorgesehen, einen zweiten Graben 30 so anzubringen, dass der zweite Graben 30 neben dem ersten Graben unmittelbar benachbart zum ersten Bereich 14 liegt. Der zweite Graben ist gemäß dieser Ausführungsform als Trenngraben ausgebildet, der die epitaktisch aufgebrachte Schicht 20 vom Bereich der Diskontinuitäten im Bereich der gestörten Zone 20' trennt.

Wie in Figur 3C gezeigt ist, bleibt die epitaktisch aufgewachsene Schicht 20' im Bereich von Seitenwänden des ersten Grabens 24 und an der Unterseite des Grabens 24 bestehen. Durch das Bilden des zweiten Grabens 30, der vorteilhafterweise die epitaktisch aufgebrachte Schicht 20 bis in das Substrat 10 hindurch trennt, ist der Bereich der gestörten Zone vom ersten Bereich 14 elektrisch isoliert, so dass die Gefahr von Nebenschlüssen nach Fertigstellung des optoelektronischen Halbleiterkörpers reduziert wird.

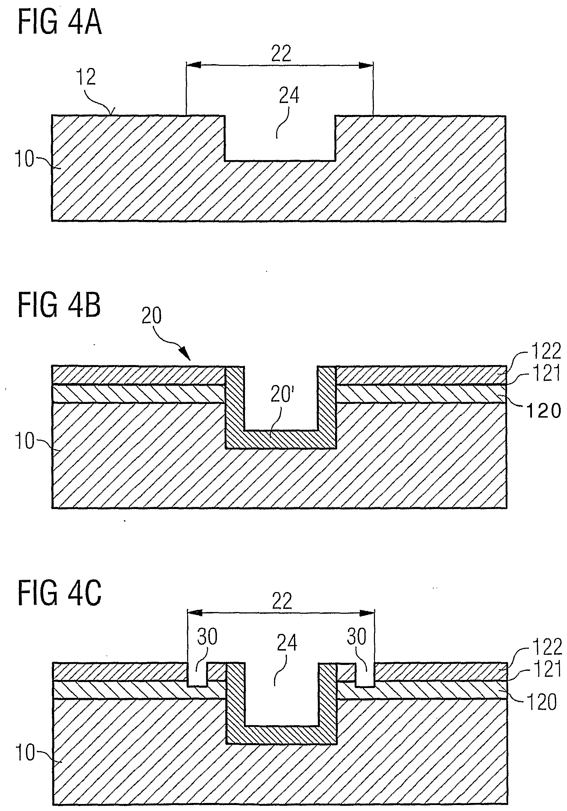

In Figur 4A ist in einem weiteren Beispiel eine weitere Ausführungsform eines optoelektronischen Halbleiterkörpers in einer Querschnittsansicht durch ein Substrat 10 vor dem epitaktischen Aufbringen der Halbleiterschichtenfolge 20 gezeigt. In Figur 4A ist im zweiten Bereich 22 der erste Graben 24 im Substrat 10 beispielsweise durch geeignete Ätzschritte unter Verwendung einer Maske gebildet worden.

Wie in Figur 4B gezeigt ist, erfolgt danach das epitaktische Aufbringen der Halbleiterschichtenfolge 20. Dabei wird in einem ersten Prozessschritt beispielsweise die n-dotierte Schicht 120 durch ein Epitaxieverfahren vollflächig auf der ersten Hauptfläche 12 des Substrats 10 abgeschieden, in einem zweiten Prozessschritt der aktive Bereich 121 und in einem dritten Prozessschritt der p-dotierte Schicht 122.

Die Halbleiterschichtenfolge 20 kann während des epitaktischen Aufwachsens insbesondere im Bereich von Seitenwänden des ersten Grabens 24, aber auch an der Unterseite des Grabens 24 eine gestörte Zone aufweisen, die auf undefinierte Schichtendicken oder unregelmäßiges Kristallwachstum der epitaktischen Halbleiterschichtenfolge 20 zurückzuführen ist. Der Bereich der möglicherweise gestörten Zone ist in Figur 4B wiederum mit dem Bezugszeichen 20' gekennzeichnet.

Wie in Figur 4C gezeigt, ist es gemäß dieser Ausführungsform vorgesehen, einen zweiten Graben 30 so anzubringen, dass der zweite Graben 30 neben dem ersten Graben 24 unmittelbar benachbart zum ersten Bereich 14 liegt. Der zweite Graben ist gemäß dieser Ausführungsform als Trenngraben ausgebildet, der die epitaktisch aufgebrachte Schicht 20 vom Bereich der Diskontinuitäten im Bereich der gestörten Zone 20' trennt.

Wie in Figur 4C gezeigt ist, bleibt die epitaktisch aufgewachsene Schicht 20' im Bereich von Seitenwänden des ersten Grabens 24 und an der Unterseite des Grabens 24 bestehen. Durch das Bilden des zweiten Grabens 30, der wenigstens die p-dotierte Schicht 122 bis zur n-dotierten Schicht 120 hindurch trennt, ist der Bereich der gestörten Zone vom ersten Bereich 14 elektrisch isoliert. Gemäß dieser Ausführungsform ist es aber auch möglich, den zweiten Graben 30 von der p-dotierten Schicht 122 bis zum Substrat 10 zu bilden.

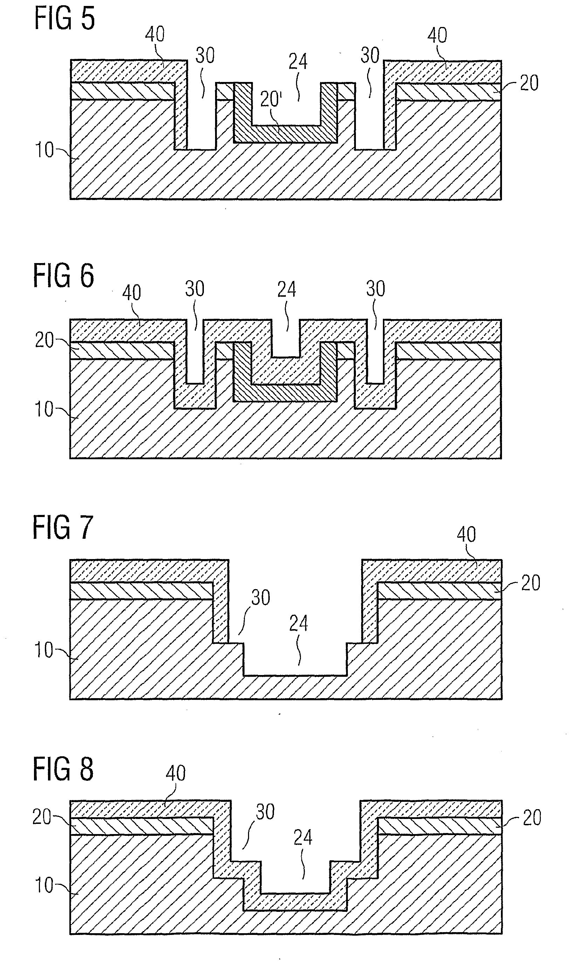

Eine weitere Verbesserung kann durch Aufbringen einer Passivierungsschicht erzielt werden, wie nachfolgend in Bezug auf die Figuren 5 bis 8 erläutert wird.

In Figur 5 ist eine Ausführungsform einer Schichtenfolge eines optoelektronischen Halbleiterkörpers in einer Querschnittsansicht gezeigt, wie sie bereits unter Bezugnahme auf Figur 3C beschrieben wurde. Nach dem Bilden des zweiten Grabens wird eine Passivierungsschicht 40 aufgebracht, die wenigstens die Seitenwände des Grabens 30 auf der dem ersten Bereich zugewandten Seite bedeckt.

Demgemäß ist zusätzlich zur Trennung der gestörten Zone der epitaktischen Halbleiterschichtenfolge zu aktiven Bereichen eine Passivierungsschicht 40 vorgesehen, die elektrische Nebenschlüsse oder Kriechströme verhindern kann sowie zur Erhöhung der ESD-Festigkeit dient. Die Passivierungsschicht 40 kann beispielsweise als eine Oxid-, Nitrid- oder Fluoridschicht gebildet werden, wobei weitere, dem Fachmann bekannte Materialien jedoch nicht ausgeschlossen sind.

In Figur 6 ist eine Ausführungsform einer Schichtenfolge eines optoelektronischen Halbleiterkörpers in einer Querschnittsansicht gezeigt, wie sie bereits unter Bezugnahme auf Figur 3C beschrieben wurde. Nach dem Bilden des zweiten Grabens wird eine Passivierungsschicht 40 aufgebracht, die im Gegensatz zu Figur 5 die erste Hauptfläche 12 vollflächig bedeckt. Die Passivierungsschicht 40 kann wiederum als eine Oxid-, Nitrid- oder Fluoridschicht gebildet werden, wobei weitere, dem Fachmann bekannte Materialien jedoch nicht ausgeschlossen sind.

In Figur 7 ist eine Schichtenfolge eines optoelektronischen Halbleiterkörpers in einer
Querschnittsansicht gezeigt, wie sie bereits unter Bezugnahme auf Figur 2C beschrieben wurde. Nach dem Bilden des zweiten Grabens wird eine Passivierungsschicht 40 aufgebracht, die wenigstens die Seitenwände des Grabens 30 auf der dem ersten Bereich zugewandten Seite bedeckt.

Demgemäß ist zusätzlich zur Trennung der gestörten Zone der epitaktischen Halbleiterschichtenfolge zu aktiven Bereichen eine Passivierungsschicht 40 vorgesehen, die elektrische Nebenschlüsse oder Kriechströme verhindern kann sowie zur Erhöhung der ESD-Festigkeit dient. Die Passivierungsschicht 40 kann beispielsweise als eine Oxid-, Nitrid- oder Fluoridschicht gebildet werden, wobei weitere, dem Fachmann bekannte Materialien jedoch nicht ausgeschlossen sind.

In Figur 8 ist eine Schichtenfolge eines optoelektronischen Halbleiterkörpers in einer Querschnittsansicht gezeigt, wie sie bereits unter Bezugnahme auf Figur 2C beschrieben wurde.

Nach dem Bilden des zweiten Grabens wird eine Passivierungsschicht 40 aufgebracht, die im Gegensatz zu Figur 7 die erste Hauptfläche 12 vollflächig bedeckt. Die Passivierungsschicht 40 kann wiederum als eine Oxid-, Nitrid- oder Fluoridschicht gebildet werden, wobei weitere, dem Fachmann bekannte Materialien jedoch nicht ausgeschlossen sind.

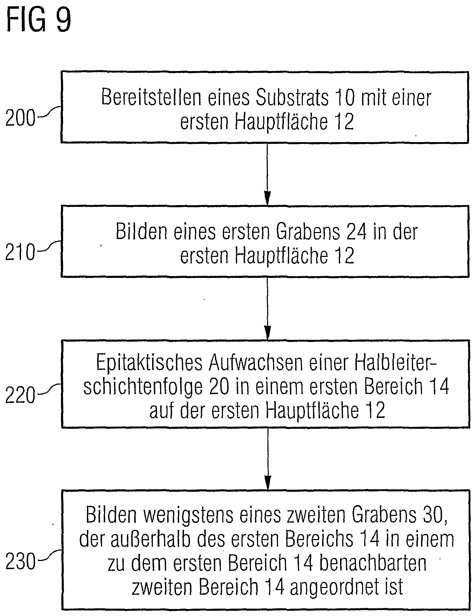

Das erfindungsgemäße Verfahren wird im Folgenden unter Bezugnahme auf Figur 9 näher erläutert, das die einzelnen Schritte anhand eines Flussdiagramms zeigt.

In Schritt 200 wird ein Substrat 10 mit einer ersten Hauptfläche 12 bereitgestellt.

In Schritt 210 erfolgt ein Bilden eines ersten Grabens 24 in der ersten Hauptfläche 12.

In Schritt 220 erfolgt ein epitaktisches Aufwachsen einer Halbleiterschichtenfolge 20, die eine zur Erzeugung der elektromagnetischen Strahlung geeignete aktive Schicht 21 aufweist, in einem ersten Bereich 14 auf der ersten Hauptfläche 12.

In Schritt 230 erfolgt ein Bilden wenigstens eines zweiten Grabens 30, der außerhalb des ersten Bereichs 14 in einem zu dem ersten Bereich 14 benachbarten zweiten Bereich 14 angeordnet ist.

Die Erfindung ist nicht durch die Beschreibung anhand der Ausführungsbeispiele beschränkt. Der Schutzbereich wird durch die Ansprüche definiert.

## Patentansprüche

1. Optoelektronischer Halbleiterkörper, umfassend
- ein Substrat (10), das auf einer ersten Hauptfläche (12) in einem ersten Bereich (14) eine zur Erzeugung von elektromagnetischer Strahlung geeignete, epitaktische Halbleiterschichtenfolge (20) und in einem zu dem ersten Bereich (14) benachbarten zweiten Bereich (22) einen ersten Graben (24) aufweist; und
- wenigstens einen zweiten Graben (30), der außerhalb des ersten Bereichs (14) im zweiten Bereich (22) angeordnet ist, wobei
- der zweite Graben (30) von einer dem Substrat (10) abgewandten Hauptfläche der epitaktischen Halbleiterschichtenfolge (20) aus die epitaktische Halbleiterschichtenfolge (20) wenigstens teilweise durchtrennt,
- die epitaktische Halbleiterschichtenfolge (20) im Bereich der Seitenwände des ersten Grabens (24) eine gestörte Zone aufweist, die auf undefinierte Schichtendicken oder unregelmäßiges Kristallwachstum der epitaktischen Halbleiterschichtenfolge (20) zurückzuführen ist,
- der zweite Graben (30) neben dem ersten Graben (24) unmittelbar benachbart zum ersten Bereich (14) liegt,
- der zweite Graben von der dem Substrat (10) abgewandten Hauptfläche bis in das darunter liegende Substrat reicht, und
- der zweite Graben (30) derart im zweiten Bereich (22) gebildet ist, dass die Seitenwände (31) des zweiten Grabens (30) im Bereich des Substrats (10) nicht von den epitaktisch aufgebrachten Schichten bedeckt sind.

2. Optoelektronischer Halbleiterkörper nach Anspruch 1,
bei dem der zweite Graben (30) als Trenngraben benachbart zum ersten Graben (24) angeordnet ist.

3. Optoelektronischer Halbleiterkörper nach Anspruch 2,
bei dem der zweite Graben (30) als Trenngraben jeweils auf beiden Seiten des ersten Grabens benachbart zum ersten Graben (24) angeordnet ist.

4. Optoelektronischer Halbleiterkörper nach einem der Ansprüche 1 bis 3,
bei dem auf der ersten Hauptfläche (12) in dem zweiten Bereich (22) eine Passivierungsschicht (40) aufgebracht ist, die den zweiten Graben (30) wenigstens teilweise bedeckt.

5. Optoelektronischer Halbleiterkörper nach Anspruch 4,
bei dem die Passivierungsschicht (40) darüber hinaus Seitenwände der epitaktischen Halbleiterschichtenfolge (20) wenigstens teilweise bedeckt.

6. Optoelektronischer Halbleiterkörper nach Anspruch 4 oder 5,
bei dem die Passivierungsschicht (40) Seitenwände des zweiten Grabens (30) wenigstens teilweise bedeckt.

7. Optoelektronischer Halbleiterkörper nach einem der Ansprüche 4 bis 6,
bei dem die Passivierungsschicht (40) den Halbleiterkörper vollständig bedeckt.

8. Optoelektronischer Halbleiterkörper nach einem der Ansprüche 4 bis 7,
bei dem die Passivierungsschicht (40) eine Oxid-, Nitrid- oder Fluoridverbindung umfasst.

9. Optoelektronischer Halbleiterkörper nach einem der Ansprüche 1 bis 8,
bei dem der erste Bereich (14) einen Laser oder eine Leuchtdiode umfasst.

10. Optoelektronischer Halbleiterkörper nach Anspruch 9,
bei dem der Laser als Rippe auf der ersten Hauptfläche (12) des Substrates (10) angeordnet ist.

11. Verfahren zur Herstellung eines optoelektronischen Halbleiterkörpers mit den Schritten:
- Bereitstellen eines Substrats (10) mit einer ersten Hauptfläche (12),
- Bilden eines ersten Grabens (24) in der ersten Hauptfläche (12),
- epitaktisches Aufwachsen einer Halbleiterschichtenfolge (20), die eine zur Erzeugung der elektromagnetischen Strahlung geeignete aktive Schicht (21) aufweist, in einem ersten Bereich (14) auf der ersten Hauptfläche (12) und im ersten Graben (24),
- Bilden wenigstens eines zweiten Grabens (30), der außerhalb des ersten Bereichs (14) in einem zu dem ersten Bereich (14) benachbarten zweiten Bereich (22) angeordnet ist, wobei
- die epitaktische Halbleiterschichtenfolge (20) im Bereich der Seitenwände des ersten Grabens (24) eine gestörte Zone aufweist, die auf undefinierte Schichtendicken oder unregelmäßiges Kristallwachstum der epitaktischen Halbleiterschichtenfolge (20) zurückzuführen ist,
- der zweite Graben (30) neben dem ersten Graben (24) unmittelbar benachbart zum ersten Bereich (14) liegt,
- der zweite Graben (30) von einer dem Substrat (10) abgewandten Hauptfläche der epitaktischen Halbleiterschichtenfolge (20) aus die epitaktische Halbleiterschichtenfolge (20) wenigstens teilweise durchtrennt,
- die Schritte des Verfahrens in der angegebenen Reihenfolge ausgeführt werden, und
- der zweite Graben von der dem Substrat (10) abgewandten Hauptfläche bis in das darunter liegende Substrat reicht.

12. Verfahren nach Anspruch 11,
bei dem ein optoelektronischen Halbleiterkörper gemäß einem der Ansprüche 1 bis 11 hergestellt wird.

## Claims

1. Optoelectronic semiconductor body, comprising
- a substrate (10), which comprises on a first main area (12) in a first region (14) an epitaxial semiconductor layer sequence (20) suitable for generating electromagnetic radiation, and a first trench (24) in a second region (22) adjacent to the first region (14); and
- at least one second trench (30) arranged outside the first region (14) in the second region (22), wherein
- the second trench (30) at least partly severs the epitaxial layer sequence (20) from a main area of the epitaxial layer sequence (20) that faces away from the substrate (10),
- the epitaxial semiconductor layer sequence (20) has a disturbed zone in the region of the sidewalls of the first trench (24), attributable to undefined layer thicknesses or irregular crystal growth of the epitaxial semiconductor layer sequence (20),
- the second trench (30) is arranged next to the first trench (24) and directly adjacent to the first region (14),
- the second trench (30) extends from the main area that faces away from the substrate (10) into the substrate arranged below, and
- the second trench (30) is formed in the second region (22) in such a way that the sidewalls (31) of the second trench (30) are not covered by the epitaxially applied layers in the region of the substrate (10).

2. Optoelectronic semiconductor body according to claim 1,
wherein the second trench (30) is arranged as a separating trench adjacent to the first trench (24).

3. Optoelectronic semiconductor body according to claim 2,
wherein the second trench (30) is arranged as a separating trench in each case on both sides of the first trench adjacent to the first trench (24).

4. Optoelectronic semiconductor body according to any of claims 1 to 3,
wherein a passivation layer (40) is applied on the first main area (12) in the second region (22), said passivation layer (40) at least partly covering the second trench (30).

5. Optoelectronic semiconductor body according to claim 4,
wherein the passivation layer (40) furthermore at least partly covers sidewalls of the epitaxial semiconductor layer sequence (20).

6. Optoelectronic semiconductor body according to claim 4 or 5,
wherein the passivation layer (40) at least partly covers sidewalls of the second trench (30).

7. Optoelectronic semiconductor body according to any of claims 4 to 6,
wherein the passivation layer (40) completely covers the semiconductor body.

8. Optoelectronic semiconductor body according to any of claims 4 to 7,
wherein the passivation layer (40) comprises an oxide, nitride or fluoride compound.

9. Optoelectronic semiconductor body according to any of claims 1 to 8,
wherein the first region (14) comprises a laser or a light-emitting diode.

10. Optoelectronic semiconductor body according to claim 9,
wherein the laser is arranged as a rib on the first main area (12) of the substrate (10).

11. Method for producing an optoelectronic semi-conductor body, the method comprising the following steps:
- providing a substrate (10) having a first main area (12),
- forming a first trench (24) in the first main area (12),
- epitaxially growing a semiconductor layer sequence (20), which comprises an active layer (21) suitable for generating the electromagnetic radiation, in a first region (14) on the first main area (12) and in the first trench (24),
- forming at least one second trench (30) arranged outside the first region (14) in a second region (22) adjacent to the first region (14), wherein
- the epitaxial semiconductor layer sequence (20) has a disturbed zone in the region of the sidewalls of the first trench (24), attributable to undefined layer thicknesses or irregular crystal growth of the epitaxial semiconductor layer sequence (20),
- the second trench (30) is arranged next to the first trench (24) and directly adjacent to the first region (14),
- the second trench (30) at least partly severs the epitaxial layer sequence (20) from a main area of the epitaxial layer sequence (20) that faces away from the substrate (10),
- the steps of the method are carried out in the indicated order, and
- the second trench (30) extends from the main area that faces away from the substrate (10) into the substrate arranged below.

12. Method according to claim 11,
wherein an optoelectronic semiconductor body according to any of claims 1 to 11 is produced.

## Revendications

1. Corps semiconducteur optoélectronique comprenant
- un substrat (10), qui présente sur une première surface principale (12) dans une première zone (14), une succession de couches semiconductrices épitaxiale adéquate pour la production d'un rayonnement électromagnétique (20) et, dans une seconde zone (22) à proximité de la première zone (14), une première tranchée (24) ; et
- au moins une seconde tranchée (30), qui est disposée dans la seconde zone (22) en dehors de la première zone (14),
- la seconde tranchée (30) séparant au moins partiellement la succession de couches semiconductrices épitaxiale (20) à partir d'une surface principale de la succession de couches semiconductrices épitaxiale (20) détournée du substrat (10),
- la succession de couches semiconductrices épitaxiale (20) présentant dans la zone des flancs de la première tranchée (24) une zone perturbée, qui est expliquée par des épaisseurs de couches non définies ou une croissance de cristaux irrégulière de la succession de couches semiconductrices épitaxiale (20),
- la seconde tranchée (30) se trouvant à côté de la première tranchée (24) à proximité directe de la première zone (14),
- la seconde tranchée s'étendant de la surface principale détournée du substrat (10) jusqu'au substrat se trouvant au-dessous, et
- la seconde tranchée (30) étant constituée de telle manière dans la seconde zone (22), que les flancs (31) de la seconde tranchée (30) ne sont pas couverts dans la zone du substrat (10) par les couches appliquées par épitaxie.

2. Corps semiconducteur optoélectronique selon la revendication 1,
pour lequel la seconde tranchée (30) est disposée comme une tranchée de séparation à proximité de la première tranchée (24) .

3. Corps semiconducteur optoélectronique selon la revendication 2,
pour lequel la seconde tranchée (30) est disposée comme une tranchée de séparation respectivement sur les deux côtés de la première tranchée à proximité de la première tranchée (24).

4. Corps semiconducteur optoélectronique selon une quelconque des revendications 1 à 3,
pour lequel, sur la première surface principale (12) est appliquée dans la seconde zone (22) une couche de passivation (40), qui couvre au moins partiellement la seconde tranchée (30) .

5. Corps semiconducteur optoélectronique selon la revendication 4,
pour lequel la couche de passivation (40) couvre par ailleurs au moins partiellement les flancs de la succession de couches semiconductrices épitaxiale (20).

6. Corps semiconducteur optoélectronique selon les revendications 4 ou 5,
pour lequel la couche de passivation (40) couvre par ailleurs au moins partiellement les flancs de la seconde tranchée (30).

7. Corps semiconducteur optoélectronique selon une quelconque des revendications 4 à 6,
pour lequel la couche de passivation (40) couvre complètement le corps semiconducteur.

8. Corps semiconducteur optoélectronique selon une quelconque des revendications 4 à 7,
pour lequel la couche de passivation (40) comporte une liaison d'oxyde, de nitrure ou de fluorure.

9. Corps semiconducteur optoélectronique selon une quelconque des revendications 1 à 8,
pour lequel la première zone (14) comporte un laser ou une diode luminescente.

10. Corps semiconducteur optoélectronique selon la revendication 9,
pour lequel le laser est disposé comme une nervure sur la première surface principale (12) du substrat (10).

11. Procédé en vue de la fabrication d'un corps semiconducteur optoélectronique, avec les étapes de :
- mise à disposition d'un substrat (10) avec une première surface principale (12),
- constitution d'une première tranchée (24) dans la première surface principale (12),
- croissance par épitaxie d'une succession de couches semiconductrices (20), qui présente une couche active (21) adéquate pour la production du rayonnement électromagnétique, dans une première zone (14) sur la première surface principale (12) et dans la première tranchée (24),
- constitution d'au moins une seconde tranchée (30), qui est disposée en dehors de la première zone (14) dans une seconde zone (22) à proximité de la première zone (14),
- la succession de couches semiconductrices épitaxiale (20) présentant dans la zone des flancs de la première tranchée (24) une zone perturbée, qui est expliquée par des épaisseurs de couches non définies ou une croissance de cristaux irrégulière de la succession de couches semiconductrices épitaxiale (20),
- la seconde tranchée (30) se trouvant à côté de la première tranchée (24) à proximité directe de la première zone (14),
- la seconde tranchée (30) séparant au moins partiellement la succession de couches semiconductrices épitaxiale (20) à partir d'une surface principale de la succession de couches semiconductrices épitaxiale (20) détournée du substrat (10),
- les étapes du procédé étant effectuées dans l'ordre indiqué, et
- la seconde tranchée s'étendant de la surface principale détournée du substrat (10) jusqu'au substrat (10) étendu au-dessous.

12. Procédé selon la revendication 11,
lors duquel un corps semiconducteur optoélectronique selon une quelconque des revendications 1 à 11 est fabriqué.
